(19) Europäisches Patentamt
European Patent Office
Office européen des brevets

(11) Publication number: **0 227 017 B1**

# (12) EUROPEAN PATENT SPECIFICATION

(45) Date of publication of patent specification: **23.10.91**

(51) Int. Cl.5: **G01R 31/08**, G01R 31/11

(21) Application number: **86117526.3**

(22) Date of filing: **17.12.86**

## (54) Method for detecting high resistance ground faults on a power transmission line.

(30) Priority: **20.12.85 SE 8506063**

(43) Date of publication of application:
**01.07.87 Bulletin 87/27**

(45) Publication of the grant of the patent:
**23.10.91 Bulletin 91/43**

(84) Designated Contracting States:
**CH DE FR GB IT LI SE**

(56) References cited:
**EP-A- 0 045 113**
**EP-A- 0 082 103**
**EP-A- 0 164 711**
**DE-A- 2 932 929**

**IEEE TRANSACTIONS ON POWER DELIVERY PWRD-1, no. 1, January 1986, pages 272-279, New York, US; M.M. MANSOUR et al.: "A Multi-Microprocessor based travelling wave relay - Theory and realisation"**

(73) Proprietor: **ASEA AB**
**S-721 83 Västeras(SE)**

(72) Inventor: **Nimmersjö, Gunnar**
**Slagbjörnsgatan 1**
**S-722 42 Västeras(SE)**

(74) Representative: **Boecker, Joachim, Dr.-Ing.**
**Rathenauplatz 2-8**
**W-6000 Frankfurt a.M. 1(DE)**

**EP 0 227 017 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The invention relates to a method for detecting high resistance ground faults on a power transmission line according to claim 1. The invention also refers to a device for carrying out the method.

The invention is designed for networks for the distribution or transmission of electric power, in which supply of power to the transmission line to be protected takes place at least from one of the end points of the transmission line, and in which that part of the network which is to be protected is provided with measuring devices in a station or the like at either end of the object to be protected.

Distribution and transmission networks have to be protected against faults in such a way that a faulty component or transmission line is automatically disconnected with the aid of an associated circuit-breaker. This is necessary to minimize the risk of personal injury and fire, and it also applies to high impedance faults with relatively small fault currents. Ground faults, in particular, may have high fault resistances.

Ground fault protection devices of prior art are determined primarily by the size of the network, its grounding and the regulations which apply to electric heavy current installations with regard to permissible voltages in the case of ground faults on a grounded component. In view of the different appearances of the networks, therefore, several different types of measurement criteria are currently used.

An ungrounded network may be used when the total length of line of the network is not too great. In that way, the ground fault current is limited by the capacitive reactance between the network and ground and by a possible transition resistance at the site of the fault. In this connection, directional current relays are used which are sensitive to ground fault currents having a capacitive phase shift relative to the neutral point voltage.

Direct-grounded networks are seldom used at the distribution level since the ground fault current may assume very high values. On the other hand, direct grounding is commonly used for the transmission networks. Since direct grounding implies that the neutral point voltage of the network is zero, the ground fault current is utilized only for selective ground fault detection or for disconnection of a faulty transmission line.

Grounding via neutral point resistors larger than 50 Ω is used in small and medium-sized networks. The neutral point resistor is chosen such that a sufficiently great active or - as it is also called - resistive current, that is, a current being in phase with the neutral point voltage, is obtained in the case of a ground fault. The network is protected by directional current relays which are sensitive to ground fault current and which are supplied with the current which passes through the neutral point resistor.

Grounding by means of a neutral point reactor and a neutral point resistor occurs in large networks, in which the capacitive ground fault current would otherwise become too high. The capacitive ground fault current is compensated for by the neutral point reactor so as to obtain a tuned network. For selective disconnection of a faulty component, current direction relays are used which are sensitive to resistive ground fault current, that is, the current through the neutral point resistor. In some applications a special automatic system is available which takes care of the disconnection and connection of the neutral point resistor so as to provide a chance of self-extinguishing of the fault before a relay starts operating and disconnects the line.

Grounding by means of neutral point reactor occurs in large distribution networks. Otherwise, the same conditions apply as in the case of grounding by means of a reactor and a resistor; however, it is presupposed that the internal resistance of the neutral point reactor shall be sufficiently high as to enable the evaluation of a resistive current component.

The components and systems for ground fault measurement, identification and disconnection which are used at present cannot, as is partly clear from the above description, be made identical because of different grounding principles. Nor do they offer the desirable sensitivity and speed.

In direct-grounded networks, however, it is theoretically possible to achieve a relatively high sensitivity of the ground fault protection devices with a possibility of selective detection of faults with high transition resistances. This type of grounding primarily applies to the transmission networks.

Ungrounded networks also provide relatively good possibilities of selective detection of ground faults with a high transition resistance. However, ungrounded networks are less common, since only small networks may come into question. In addition, it is normally desired to avoid ungrounded networks in view of the risk of intermittent ground faults.

In networks which are resistance-grounded corresponding to a ground fault current of 2-15 A and networks with reactor grounding together with resistance grounding, directional current relays which are sensitive to resistive ground fault currents give varying sensitivity to ground faults with a high transition resistance. The sensitivity is largely dependent on the size of the network. Generally, however, it can be said that large networks give limited possibilities of good selective detection of

high-ohmic ground faults.

The three most important reasons for the limited sensitivity of current direction relays which are sensitive to resistive ground fault current are as follows:

In the case of low ground fault currents, where the capacitive or the inductive component of the current is predominant, the angular fault of the current transformer may cause incorrect measurement.

In the case of faults with a low degree of propagation, power and current direction relays have difficulties in measuring I x cos $\alpha$ in the case of great values of $\alpha$, that is, in the range $\alpha = 80^\circ - 90^\circ$.

For practical reasons it is not possible to set the sensitivity of the relays at an arbitrarily high level. The reasons may be leakage currents in insulators, spontaneous ground contacts through vegetation or salt storms near sea shores. Too high a sensitivity of the ground fault protection devices would therefore result in unjustified trippings.

It is an express wish on the part of the distributors of electric power to detect ground faults with a higher transition resistance at the site of the fault than what is possible at present (~3 kΩ). In many transmission networks ground faults with high fault resistances may also occur. These faults are difficult to detect with, for example, impedance relays.

It is a well known fact that ground faults which are not located and disconnected in time may lead to personal injury or fire. Of special interest in this connection are reversed ground faults, that is, faults in which a phase is interrupted and a ground fault arises in the phase after the point of interruption involving feeding via the load object. In the present situation these faults may remain undiscovered for a long period of time.

In addition to the above general description of the various designs of ground fault protection devices and the associated problems, the description of the prior art should also include a reference to EP-B-0 082 103 (Jan Bergman). This document describes a method and a device for detecting ground faults in networks for distribution of electric power from a power station from which a number of transmission lines emanate and in which the ground fault current of each line is measured. According to this method, that line is selected which exhibits the greatest active ground fault current or the greatest ground fault current or the greatest change in ground fault current. Thereafter, the measured ground fault current, or the change therein, in the selected transmission line is compared with at least one predetermined reference value. A fault indication takes place when the measured value exceeds the reference value.

The invention will now be described in greater detail with reference to the accompanying drawings showing - by way of example - in

- Figure 1 a power transmission line in faultless condition between two stations P and Q which are fed from two power sources A and B,
- Figure 2 the real voltage distribution along the transmission line in Figure 1 between the two power sources,
- Figure 3 the same voltage distribution, in which the voltage values have been calculated by means of a travelling wave model located at P or at Q, based on voltage and current values measured at P and Q,
- Figure 4 the same transmission line as in Figure 1 with a fault at F between P and Q,
- Figure 5 the measured voltage along the transmission line after the occurrence of a high resistance fault,
- Figure 6 the voltage difference $\Delta U$ along the transmission line between the measured or calculated voltage prior to a fault and the voltage calculated with a travelling wave model after a fault,
- Figure 7 an embodiment of a device for detection of a high resistance fault according to the invention with a digital travelling wave model.

Figure 1 shows a power line between two stations or measuring points P and Q. In the example shown the line is fed from two power sources A and B. More generally the line between P and Q can be conceived to be a transmission line between two networks A and B, a line in a meshed network or a line which connects a power station A with a complex power consumer B.

Figure 2 shows the real voltage distribution along the line in a faultless state. $E_A$ and $E_B$, respectively, are the E.M.F.s of the respective power sources, and $U'_P$ and $U'_Q$, respectively, are the measured voltage at P and at Q, respectively.

In EP-A-0164711 it is described how a so-called travelling wave model of a transmission line can be used for calculating the voltage distribution along that line. These calculations are based on the propagation of voltage waves along the line. The method comprises carrying out, at certain regular time intervals, a measurement of the instantaneous values of the current and the voltage at the end point of the line, for example in a station. With these values and with the aid of the travelling wave model, the voltage can be calculated at a number of control points along the line, thus obtaining the voltage distribution along the line.

With the aid of the current and voltage values

measured in the stations P and Q, the control voltages or the voltage distribution from P towards Q along the line and from Q towards P in a faultless state can be calculated with the travelling wave model (see Figure 3). This means that the same voltage distribution is obtained as in Figure 2 within the limits which are determined by errors in measurement in measuring transformers and by an uncertain knowledge of parameters.

In an ideal transmission system, the zero sequence voltage and the negative sequence voltage are zero under faultless conditions. In practice they can be assumed to be small. This applies particularly to that part of the zero sequence voltage and the negative sequence voltage which is caused by asymmetry in the monitored transmission line. The voltage change which occurs as a result of a fault may either be conceived to be the difference voltage $\Delta U$ which, in accordance with the theorem of Helmholtz-Thevenin, arises at the different points of the networks as a result of the fault, or only the zero sequence component and the negative sequence component, respectively, of this change. The conclusions drawn are valid for all interpretations of $\Delta U$. In the faultless case, thus, $\Delta U = O$ at all measuring points.

When the transmission line according to Figure 1 is subjected to an internal fault, that is, a fault located between the measuring points P and Q as indicated at F in Figure 4, a real voltage distribution is obtained according to Figure 5. The greatest voltage change $\Delta U_F$ occurs at the site of the fault F. The actual measured voltage at the points P and Q are now represented as $U''_P$ and $U''_Q$.

In the following description the sign ' will indicate the values of quantities prior to the occurrence of a fault and the sign " will indicate the values of quantities after the occurrence of a fault. Further, the following indexing system is used to define the quantities in question:

An index containing P indicates that the quantity in question has been calculated with values measured at the measuring point P.

An index containing Q indicates that the quantity in question has been calculated with values measured at the measuring point Q.

An index containing p indicates that the value of the quantity in question is calculated for the point P.

An index containing q indicates that the value of the quantity in question is calculated for the point Q.

This means, for example, that $U_{Pq}$ indicates a voltage at Q calculated with values measured at P.

With the aid of this system, the following difference voltages will now be defined:

$$\Delta U_{Pp} = U'_P - U''_P \quad (1)$$
$$\Delta U_{Qq} = U'_Q - U''_Q \quad (2)$$
$$\Delta U_{Pq} = U'_{Pq} - U''_{Pq} \quad (3)$$
$$\Delta U_{Qp} = U'_{Qp} - U''_{Qp} \quad (4)$$

The zero sequence component in the changes is obtained by forming the sum of the phase voltages $U'_R$, $U'_S$ and $U'_T$. Prior to occurrence of a fault $U''_R + U''_S + U''_T = O$, and a simple calculation of $(\Delta U_{Pp})_O$, $(\Delta U_{Qq})_O$, $(\Delta U_{Pq})_O$ and $(\Delta U_{Qp})_O$ in all the cases is obtained as

$$(\Delta U)_O = U'_O = U'_R + U'_S + U'_T.$$

The negative sequence component can be obtained by means of some known type of negative sequence filter.

In Figure 6 the voltage differences according to equations (1), (2), (3) and (4) are plotted graphically. It can be determined that a device at P for calculating the voltage distribution from P towards Q has a line model which is correct between P and F but incorrect at point F, and therefore the calculated voltage distribution is incorrect for the distance FQ. In similar manner, a device at Q provides a correct picture of the voltage distribution between Q and F but an incorrect picture of the voltage distribution between F and P. The two devices together give a correct distribution of the voltage namely the device at P for the distance PF and the device at Q for the distance QF. F is the only point for which the two devices give the same model voltage.

The voltage differences $\Delta P$ and $\Delta Q$, as they are represented in Figure 6, that is,

$$\Delta P = \Delta U_{Qp} - \Delta U_{Pp} \quad (5)$$
$$\Delta Q = \Delta U_{Pq} - \Delta U_{Qq} \quad (6)$$

constitute respectively an error in measurement at Q as regards the voltage change at P and an error in measurement at P as regards the voltage change at Q, because of the fact that the models in the case of a fault at F are not correct for the whole transmission line. $\Delta P$ and $\Delta Q$ can therefore be referred to as model error voltages which are always zero if the real transmission line and the model are in accordance. The model error voltage can now be utilized for ground fault indication, since in a faultless state both $\Delta P$ and $\Delta Q$ shall be zero. In equations (5) and (6), the mean value, the peak value or the R.M.S. of the difference voltages may be used.

From a practical point of view, fault detection occurs when

$$\Delta P > \epsilon_p \quad (7)$$

or when

$\Delta Q > \epsilon_q$ (8)

where $\epsilon_p$ is the accepted voltage difference at P and and $\epsilon_q$ is the corresponding value of Q. By trimming these values under normal operation, it is possible, especially when changes in zero sequence voltages are to be sensed for ground fault detection, to set the protection device for high-ohmic faults which give greater deviations of $\epsilon_p$ and $\epsilon_q$, respectively.

Since the mathematical model for calculating the control voltage along the transmission line gives an accurate description of the voltage on the line within the limits determined by errors in measurement etc., this means that also high resistance faults can be discovered. This means that the prior art problems with detection of high resistance faults, as described above, can be overcome.

As stated, the complete travelling wave model provides control voltages along the whole transmission line. As will be clear from the description of the invention, what is necessary for the fault detection is really only access to the control voltage at the two end points calculated with measured values for the respective opposite end point of the protected line. This means that it is also possible to use a simplified version of the travelling wave model and that the device for carrying out the method according to the invention will therefore be of a considerably simpler design than if a complete voltage distribution with the model is to be achieved.

The method and the device according to the invention can be applied to phase voltages, principal voltages as well as to zero sequence and negative sequence voltages.

An embodiment of a device for carrying out the method according to the invention is shown in Figure 7. Voltages $u_{RP}$, $u_{SP}$, $u_{TP}$ and currents $i_{RP}$, $i_{SP}$, $i_{TP}$, measured in analog manner in station P are converted to digital signals in the measured value convertor 1. The corresponding conversion of measured values in station Q is performed in the convertor 2. The digital measured values are each supplied to a respective digital travelling wave model 3 and 4.

As will be clear from the above description of the method, the fault detection can take place with the aid of a phase voltage, a principal voltage, a zero sequence voltage or a negative sequence voltage. Thus, the voltage values U delivered from the travelling wave model can be anyone of the afore-mentioned voltages; however, the choice of the kind voltage must be the same for all voltage values, for example all values U must be principal voltages.

The value of $U''_P$, which may be a mean value of the voltage in question during one period, is compared in the summator 5 with $U'_P$, that is, the mean value of the same voltage measured for the preceding period. In stationary and faultless state, the difference $\Delta U_{Pp}$ is zero. When a new measured value for the next period becomes available, an existing $U''_P$ is transferred into a new $U'_P$ and the new measured value forms a new $U''_P$. This shifting and updating takes place continuously up to the point where a fault occurs, whereby $\Delta U_{Pp}$ receives a new value different from zero.

With the aid of voltage and current values measured at P, the voltage $U''_{Pq}$, that is, the voltage in station Q, as well as the value of $U'_{Pq}$, that is, the value one period earlier, can be calculated with the travelling wave model. These two values are compared with each other in the summator 6, which delivers the difference $\Delta U_{Pq}$.

Instead of forming the voltage differences from values in one period and one period earlier, the time interval between the values may also be only half a period, depending on how the filtration is performed.

To execute the equations (5) and (6), that is, to form the differences $\Delta P$ and $\Delta Q$, the values of $\Delta U_{Qq}$ and $\Delta U_{Qp}$ must be transferred to station P. This transfer takes place by means of a transmitter 9 in station Q and a receiver 10 in station P. Of course, the execution may instead take place in station Q, whereby the values of $\Delta U_{Pp}$ and $\Delta U_{Pq}$ must be transferred in a respective manner from station P to station Q.

In accordance with equation (5) the difference voltage value $\Delta P$ is then formed in a summator 11 and the corresponding value $\Delta Q$ is formed in a summator 12. If $\Delta P$ exceeds the accepted difference voltage $\epsilon_p$ in station P, a fault detection signal $F_p$ is obtained from the comparison element 13, and in similar manner a fault detection signal $F_q$ is obtained from the comparison element 14 when $\Delta Q$ exceeds $\epsilon_q$. Since a transfer of $\Delta U_{Qq}$ and $\Delta U_{Qp}$ cannot take place without channel time delay, $\Delta U_{Pq}$ and $\Delta U_{Pp}$ are delayed by a corresponding time interval before $\Delta P$ and $\Delta Q$ are formed.

The components included in the device, such as analog-digital convertors, travelling wave model, summators and comparison elements, can of course be integrated to differing degrees according to modern techniques.

In an alternative analog design, the units 1 and 2 consist of analog measured value convertors/interface units and the units 2 and 4 of analog travelling wave models. The further signal processing is then also suitably performed in analog units.

As stated in the above description of the method, alternative embodiments of the device comprise using a complete travelling wave model by means of which the voltage distribution can be calculated along the whole transmission line between P and Q, or using a simplified model which only calculates a control voltage in the respective opposite station.

## Claims

1. Method for detecting high resistance ground faults on a power transmission line located between two stations P, Q, which line is included in a multi-phase distribution or transmission system, with measuring of current and voltage in each phase at the two end points P, Q of the transmission line, with supplying the measured values to a travelling wave model (2, 3) in the respective station and with obtaining the voltage distribution along the transmission line, seen both from station P to station Q and from station Q to station P, with the aid of the travelling wave models, whereby

   $\Delta U_{Pp}$ is formed as the difference between the voltage $U'_P$, measured in station P or calculated by means of the travelling wave model, and the corresponding voltage $U''_P$ one period or one half-period later,

   $\Delta U_{Qq}$ is formed as the difference between the voltage $U'_Q$, measured in station Q or calculated by means of the travelling wave model, and the corresponding voltage $U''_Q$ one period or one half-period later,

   $\Delta U_{Pq}$ is formed as the difference between the voltage $U'_{Pq}$ in station Q, calculated in the travelling wave model in station P with values of currents and voltages measured in station P, and the corresponding voltage $U''_{Pq}$ one period or one half-period later,

   $\Delta U_{Qp}$ is formed as the difference between the voltage $U'_{Qp}$ in station P, calculated in the travelling wave model in station Q with values of currents and voltages measured in station Q, and the corresponding voltage $U''_{Qp}$ one period or one half-period later,

   $\Delta P$ is formed as the difference between $\Delta U_{Qp}$ and $\Delta U_{Pp}$,

   $\Delta Q$ is formed as the difference between $\Delta U_{Pq}$ and $\Delta U_{Qq}$

   and fault detection is obtained when

   $\Delta P > \epsilon_p$ or when $\Delta Q > \epsilon_q$

   where $\epsilon_p$ is the accepted voltage difference at P and $\epsilon_q$ is the accepted voltage difference at Q.

2. Method according to claim 1, **characterized** in that $\Delta U_{Pp}$, $\Delta U_{Qq}$, $\Delta U_{Pq}$ and $\Delta U_{Qp}$ are formed as differences of phase voltages or principal voltages for the same period/half-period.

3. Method according to claim 1 or 2, **characterized** in that the travelling wave models are designed such as to allow the calculation of the voltage distribution along the entire transmission line, seen from the respective station.

4. Method according to claim 1 or 2, **characterized** in that the travelling wave models are designed such as to allow only the calculation of the voltage in each separate station and its respective opposite station.

5. Method according to any of the preceding claims, **characterized** in that voltages delivered from the travelling wave models consist of phase voltages.

6. Method according to any of claims 1 to 4, **characterized** in that voltages delivered from the travelling wave models-consist of principal voltages.

7. Method according to any of the preceding claims, **characterized** in that voltages delivered from the travelling wave models consist of zero sequence or negative sequence voltages.

8. Device for carrying out the method according to any of the preceding claims comprising two members located in both stations, these members consisting of analog-digital convertors (1, 2), digital travelling wave models (3, 4), summators (5, 6, 7, 8, 11, 12), a transmitter (9) and a receiver (10) and elements (13, 14) for comparison with predetermined values ($\epsilon_p$, $\epsilon_q$), wherein

   a first summator (5) is arranged to form a difference voltage $\Delta U_{Pp}$ equal to the difference between the voltage ($U'_P$), measured in station P or calculated by means of the travelling wave model, and the corresponding voltage ($U''_P$) one period or one half-period later,

   a second summator (7) is arranged to form a difference voltage $\Delta U_{Qq}$ equal to the difference

between the voltage ($U'_Q$), measured in station Q or calculated by means of the travelling wave model, and the corresponding voltage ($U''_Q$) one period or one half-period later,

a third summator (6) is arranged to form a difference voltage $\Delta U_{Pq}$ equal to the difference between the voltage ($U'_{Pq}$) in station Q, calculated in the travelling wave model in station P with values of currents and voltages measured in station P, and the corresponding voltage ($U''_{Pq}$) one period or one half-period later,

a fourth summator (8) is arranged to form a difference voltage $\Delta U_{Qp}$ equal to the difference between the voltage ($U'_{Qp}$) in station P, calculated in the travelling wave model in station Q with values of currents and voltages measured in station Q, and the corresponding voltage ($U''_{Qp}$) one period or one half-period later,

the difference voltages ($\Delta U_{Qp}$, $\Delta U_{Qq}$ and $\Delta U_{Pp}$,$\Delta U_{Pq}$, respectively) are adapted to be transferred, via a transmitter and a receiver, from station Q to station P and/or from station Q to station P,

a fifth summator (11) is arranged to form the difference $\Delta P = \Delta U_{Pp} - \Delta U_{Qq}$,

a sixth summator (12) is arranged to form the difference $\Delta Q = \Delta U_{Pq} - \Delta U_{Qq}$,

the device is arranged to deliver, via a first comparison member (13), a first signal ($F_p$) indicating a high resistance ground fault when $\Delta P$ is greater than the voltage difference $\epsilon_p$ accepted at P,

and the device is arranged to deliver, via a second comparison member (14), a second signal ($F_q$) indicating a high resistance ground fault when $\Delta Q$ is greater than a voltage difference $\epsilon_q$ accepted at Q.

9. Device according to claim 9, **characterized** in that the members included are arranged for analog signal processing.

## Revendications

1. Procédé pour détecter des défauts à la terre à résistance élevée sur une ligne de transport d'énergie se trouvant entre deux stations P, Q, cette ligne faisant partie d'un système de distribution ou de transport polyphasé, comprenant la mesure du courant et de la tension dans chaque phase à deux extrémités P, Q de la ligne de transport, l'application des valeurs mesurées à un modèle d'ondes progressives (2, 3) dans la station respective, et l'obtention de la distribution de tension le long de la ligne de transport, considérée à la fois de la station P vers la station Q et de la station Q vers la station P, à l'aide des modèles d'ondes progressives, dans lequel :

   $\Delta U_{Pp}$ est formée par la différence entre la tension $U'_P$, mesurée dans la station P ou calculée au moyen du modèle d'ondes progressives, et la tension correspondante $U''_P$, une période ou une demi-période plus tard,

   $\Delta U_{Qq}$ est formée par la différence entre la tension $U'_Q$, mesurée dans la station Q ou calculée au moyen du modèle d'ondes progressives, et la tension correspondante $U''_Q$ une période ou une demi-période plus tard,

   $\Delta U_{Pq}$ est formée par la différence entre la tension $U'_{Pq}$ dans la station Q, calculée par le modèle d'ondes progressives dans la station P, avec des valeurs de courants et de tensions mesurées dans la station P, et la tension correspondante $U''_{Pq}$ une période ou une demi-période plus tard,

   $\Delta U_{Qp}$ est formée par la différence entre la tension $U'_{Qp}$ dans la station P, calculée par le modèle d'ondes progressives dans la station Q, avec des valeurs de courants et de tensions mesurées à la station Q, et la tension correspondante $U''_{Qp}$ une période ou une demi-période plus tard,

   $\Delta P$ est formée par la différence entre $\Delta U_{Qp}$ et $\Delta U_{Pp}$,

   $\Delta Q$ est formée par la différence entre $\Delta U_{Pq}$ et $\Delta U_{Qq}$

   et la tension de défaut est obtenue lorsque $\Delta P > \epsilon_p$ ou lorsque $\Delta Q > \epsilon_q$ en désignant par $\epsilon_p$ la différence de tension admise en P, et par $\epsilon_q$ la différence de tension admise en Q.

2. Procédé selon la revendication 1, **caractérisé** en ce que $\Delta U_{Pp}$, $\Delta U_{Qq}$, $\Delta U_{Pq}$ et $\Delta U_{Qp}$ sont formées par des différences de tensions de phase ou de tensions principales pour la même période/demi-période.

3. Procédé selon la revendication 1 ou 2, caractérisé en ce que les modèles d'ondes progressives sont conçus de façon à permettre le calcul de la distribution de tension le long de la totalité de la ligne de transport, vue de la station respective.

4. Procédé selon la revendication 1 ou 2, **caractérisé** en ce que les modèles d'ondes progressives sont conçus de façon à permettre

seulement le calcul de la tension dans chaque station séparée et dans sa station opposée respective.

5. Procédé selon l'une quelconque des revendications précédentes, **caractérisé** en ce que les tensions qui sont fournies par les modèles d'ondes progressives sont des tensions de phase.

6. Procédé selon l'une quelconque des revendications I à 4, **caractérisé** en ce les tensions qui sont fournies par les modèles d'ondes progressives sont des tensions principales.

7. Procédé selon l'une quelconque des revendications précédentes, **caractérisé** en ce que les tensions qui sont fournies par les modèles d'ondes progressives sont des tensions de composantes homopolaires ou inverses.

8. Dispositif pour la mise en oeuvre du procédé selon l'une quelconque des revendications précédentes, comprenant deux unités situées aux deux stations, ces unités comprenant des convertisseurs analogique-numérique (1, 2), des modèles d'ondes progressives numériques (3, 4), des circuits de sommation (5, 6, 7, 8, 11, 12), un émetteur (9) et un récepteur (10), et des éléments (13, 14) pour la comparaison avec des valeurs prédéterminées ($\epsilon_p$,$\epsilon_q$), dans lequel

un premier circuit de sommation (5) est conçu de façon à former une tension de différence $\Delta U_{Pp}$ qui est égale à la différence entre la tension ($U'_P$), mesurée à la station P ou calculée au moyen du modèle d'ondes progressives, et la tension correspondante ($U''_P$) une période ou une demi-période plus tard,

un second circuit de sommation (7) est conçu pour former une tension de différence $\Delta U_{Qq}$ égale à la différence entre la tension ($U'_Q$) mesurée à la station Q ou calculée au moyen du modèle d'ondes progressives, et la tension correspondante ($U''_Q$) une période ou une demi-période plus tard,

un troisième circuit de sommation (6) est conçu pour former une tension de différence $\Delta U_{Pq}$ égale à la différence entre la tension ($U'_{Pq}$) à la station Q, calculée par le modèle d'ondes progressives à la station P avec des valeurs de courants et de tensions mesurées à la station P, et la tension correspondante ($U''_{Pq}$) une période ou une demi-période plus tard,

un quatrième circuit de sommation (8) est conçu pour former une tension de différence $\Delta U_{Qp}$ égale à la différence entre la tension ($U'_{Qp}$) à la station P, calculée par le modèle d'ondes progressives à la station Q, avec des valeurs de courants et de tensions mesurées à la station Q, et la tension correspondante ($U''_{Qp}$) une periode ou une demi-période plus tard,

les tensions de différence (respectivement $\Delta U_{Qp}$,$\Delta U_{Qq}$ et $\Delta U_{Pp}$, $\Delta U_{Pq}$) peuvent être transférées, par l'intermédiaire d'un émetteur et d'un récepteur, de la station Q vers la station P, et/ou de la station Q vers la station P,

un cinquième circuit de sommation (11) est conçu pour former la différence $\Delta P = \Delta U_{Pp} - \Delta U_{Qp}$,

un sixième circuit de sommation (12) est conçu pour former la différence $\Delta Q = \Delta U_{Pq} - \Delta U_{Qq}$,

le dispositif est conçu pour fournir, par l'intermédiaire d'un premier élément de comparaison (13), un premier signal ($F_p$) qui indique un défaut à la terre à résistance élevée lorsque $\Delta P$ est supérieure à la différence de tension $\epsilon_p$ qui est admise en P,

et le dispositif est conçu pour fournir, par l'intermédiaire d'un second élément de comparaison (14), un second signal ($F_q$) indiquant un défaut à la terre à résistance élevée, lorsque $\Delta Q$ est supérieure à une différence de tension $\epsilon_q$ qui est admise en Q.

9. Dispositif selon la revendication 8, **caractérisé** en ce que les unités incorporées sont conçues pour effectuer un traitement de signal analogique.

## Patentansprüche

1. Verfahren zur Feststellung hochohmiger Erdschlußfehler einer Starkstromübertragungsleitung zwischen zwei Stationen P, Q, welche Leitung zu einem mehrphasigen Verteiler- oder Übertragungssystem gehört, bei welchem Verfahren Strom und Spannung jeder Phase in den beiden Endpunkten P, Q der Übertragungsleitung gemessen werden, die Meßwerte einem Wanderwellenmodell (2, 3) in der zugehörigen Station zugeführt werden und mit Hilfe des Wanderwellenmodells die Spannungsverteilung längs der Übertragungsleitung, gesehen sowohl von der Station P zu der Station Q als auch von der Station Q zu der Station P, ermittelt wird, wobei

die Differenz $\Delta U_{Pp}$ gebildet wird aus der Spannung $U'_P$, die in der Station P gemessen oder mittels des Wanderwellenmodells berechnet wird, und der eine Periode oder eine halbe Periode später auftretenden entsprechenden Spannung $U''_P$,

die Differenz $\Delta U_{Qq}$ gebildet wird aus der Spannung $U'_Q$, die in der Station Q gemessen oder mittels des Wanderwellenmodells berechnet wird, und der eine Periode oder eine halbe Periode später auftretenden entsprechenden Spannung $U''_Q$,

die Differenz $\Delta U_{Pq}$ gebildet wird aus der Spannung $U'_{Pq}$ in der Station Q, die in dem Wanderwellenmodell in der Station P mit in der Station P gemessenen Strom- und Spannungswerten berechnet wurde, und der eine Periode oder eine halbe Periode später auftretenden entsprechenden Spannung $U''_{Pq}$,

die Differenz $\Delta U_{Qp}$ gebildet wird aus der Spannung $U'_{Qp}$ in der Station P, die in dem Wanderwellenmodell in der Station Q mit in der Station Q gemessenen Strom- und Spannungswerten berechnet wurde, und der eine Periode oder eine halbe Periode später auftretenden entsprechenden Spannung $U''_{Qp}$,

die Differenz $\Delta$ P gebildet wird aus $\Delta U_{Qp}$ and $\Delta U_{Pp}$,

die Differenz $\Delta Q$ gebildet wird aus $\Delta U_{Pq}$ and $\Delta U_{Qq}$

und eine Fehlerfeststellung stattfindet, wenn

$\Delta$ P > $\epsilon_p$ oder wenn $\Delta$ Q > $\epsilon_q$,

wobei $\epsilon_p$ die zugelassene Spannungsdifferenz in P und $\epsilon_q$ die zugelassene Spannungsdifferenz in Q ist.

**2.** Verfahren nach Anspruch 1, **dadurch gekennzeichnet**, daß $\Delta U_{Pp}$, $\Delta U_{Qq}$, $\Delta U_{Pq}$ und $\Delta U_{Qp}$ als Differenzen aus den Phasenspannungen oder den verketteten Spannungen für dieselbe Periode/Halbperiode gebildet werden.

**3.** Verfahren nach Anspruch 1 oder 2, **dadurch gekennzeichnet**, daß die Wanderwellenmodelle so beschaffen sind, daß sie die Berechnung der Spannungsverteilung längs der gesamten Übertragungsleitung erlauben, gesehen von der entsprechenden Station.

**4.** Verfahren nach Anspruch 1 oder 2, **dadurch gekennzeichnet**, daß die Wanderwellenmodelle so beschaffen sind, daß sie nur die Berechnung der Spannung in jeder separaten Station und ihrer entsprechenden gegenüberliegenden Station erlauben.

**5.** Verfahren nach einem der vorhergehenden Ansprüche, **dadurch gekennzeichnet**, daß die von den Wanderwellenmodellen gelieferten Spannungen Phasenspannungen sind.

**6.** Verfahren nach einem der Ansprüche 1 bis 4, **dadurch gekennzeichnet**, daß die von den Wanderwellenmodellen gelieferten Spannungen verkettete Spannungen sind.

**7.** Verfahren nach einem der vorhergehenden Ansprüche, **dadurch gekennzeichnet**, daß die von den Wanderwellenmodellen gelieferten Spannungen aus den Null-Spannungen oder dem gegenläufigen Spannungen bestehen.

**8.** Anordnung zur Durchführung des Verfahrens nach einem der vorhergehenden Ansprüche mit zwei in den beiden Stationen angeordneten Schaltungen, die aus Analog-Digital-Wandlern (1, 2), digitalen Wanderwellenmodellen (3, 4), Summierungsgliedern (5, 6, 7, 8, 11, 12), einem Transmitter (9) und einem Empfänger (10) sowie Gliedern (13, 14) zum Vergleich mit vorgegebenen Werten ($\epsilon_p$, $\epsilon_q$) bestehen, wobei

ein erstes Summierungsglied (5) vorhanden ist zur Bildung einer Differenzspannung $\Delta U_{Pp}$, die gleich der Differenz aus der Spannung ($U'_P$), die in der Station P gemessen oder mittels des Wanderwellenmodells berechnet wird, und der entsprechenden Spannung ($U''_P$) ist, die eine Periode oder eine halbe Periode später erscheint,

ein zweites Summierungsglied (7) vorhanden ist zur Bildung einer Differenzspannung $\Delta U_{Qq}$, die gleich der Differenz aus der Spannung ($U'_Q$), die in der Station Q gemessen oder mittels des Wanderwellenmodells berechnet wird, und der entsprechenden Spannung ($U''_Q$) ist, die eine Periode oder eine halbe Periode später erscheint,

ein drittes Summierungsglied (6) vorhanden ist zur Bildung einer Differenzspannung $\Delta U_{Pq}$, die gleich der Differenz aus der Spannung ($U'_{Pq}$) in der Station Q, die in dem Wanderwellenmodell in der Station P mit in der Station P gemessenen Strom- und Spannungswerten berechnet wurde, und der entsprechenden Spannung ($U''_{Pq}$) ist, die eine Periode oder eine halbe Periode später erscheint,

ein viertes Summierungsglied (8) vorhanden ist zur Bildung einer Differenzspannung $\Delta U_{Qq}$, die gleich der Differenz aus der Spannung ($U'_{Qp}$) in der Station P, die in dem Wanderwellenmodell in der Station Q mit in der Station Q gemessenen Strom- und Spannungswerten berechnet wurde, und der entsprechenden Spannung ($U''_{Qp}$) ist, die eine Periode oder eine halbe Periode später erscheint,

die Differenzspannungen ($\Delta U_{Qp}$, $\Delta U_{Qq}$ beziehungsweise $\Delta U_{Pp}$, $\Delta U_{Pq}$) über einen Transmitter und einen Empfänger von der Station Q zu der Station P und/oder von der Station Q zu der Station P übertragen werden können,

ein fünftes Summierungsglied (11) vorhanden ist zur Bildung der Differenz $\Delta P = \Delta U_{Pp} - \Delta U_{Qp}$,

ein sechstes Summierungsglied (12) vorhanden ist zur Bildung der Differenz $\Delta Q = \Delta U_{Pq} - \Delta U_{Qq}$,

die Anordnung über ein erstes Vergleichsglied (13) ein erstes Signal ($F_p$) liefert, welches einen hochohmigen Erdschlußfehler anzeigt, wenn $\Delta P$ größer ist als die Spannungsdifferenz $\epsilon_p$, die in P zugelassen wird,

und die Anordnung über ein zweites Vergleichsglied (14) ein zweites Signal ($F_q$) liefert, welches einen hochohmigen Erdschlußfehler anzeigt, wenn $\Delta$ Q größer ist als die Spannungsdifferenz $\epsilon_q$, die in Q zugelassen wird.

**9.** Anordnung nach Anspruch 9, **dadurch gekennzeichnet**, daß die darin enthaltenen Schaltungen analoge Signale zu verarbeiten vermögen.

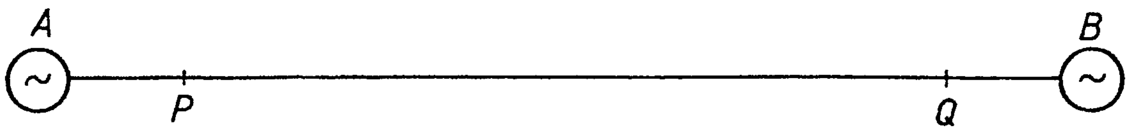


FIG.1

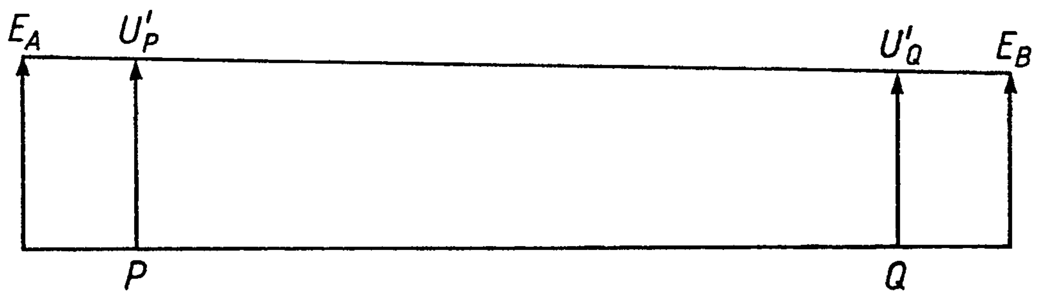


FIG.2

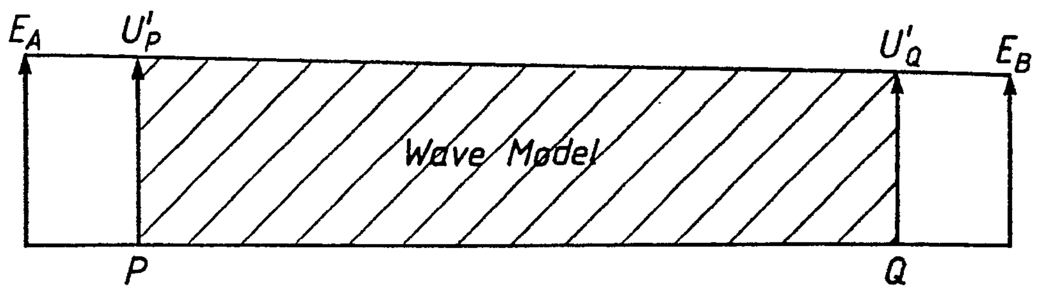


FIG.3

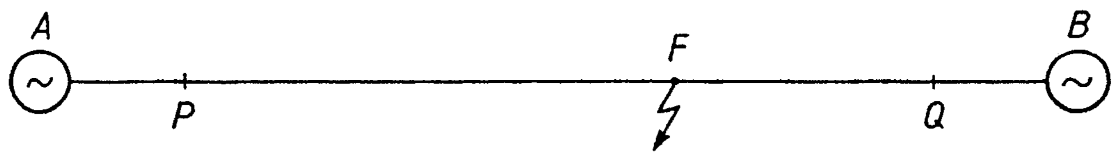


FIG. 4

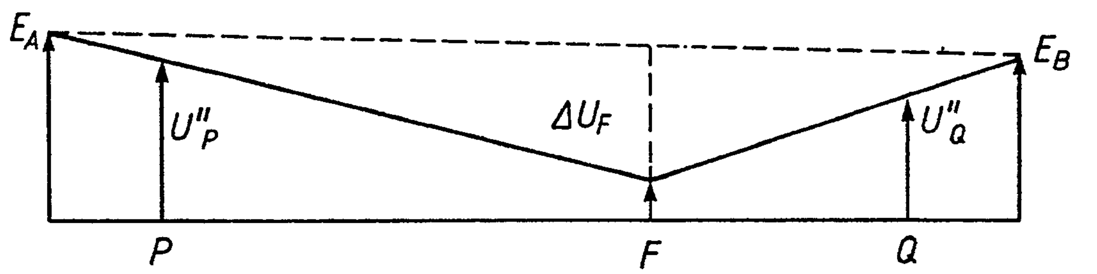


FIG. 5

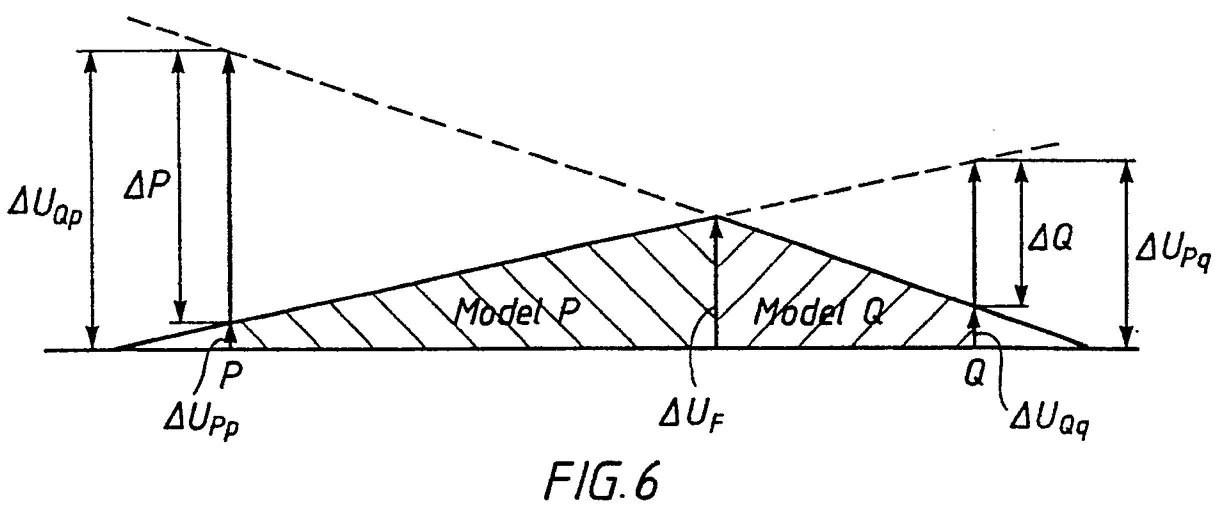


FIG. 6

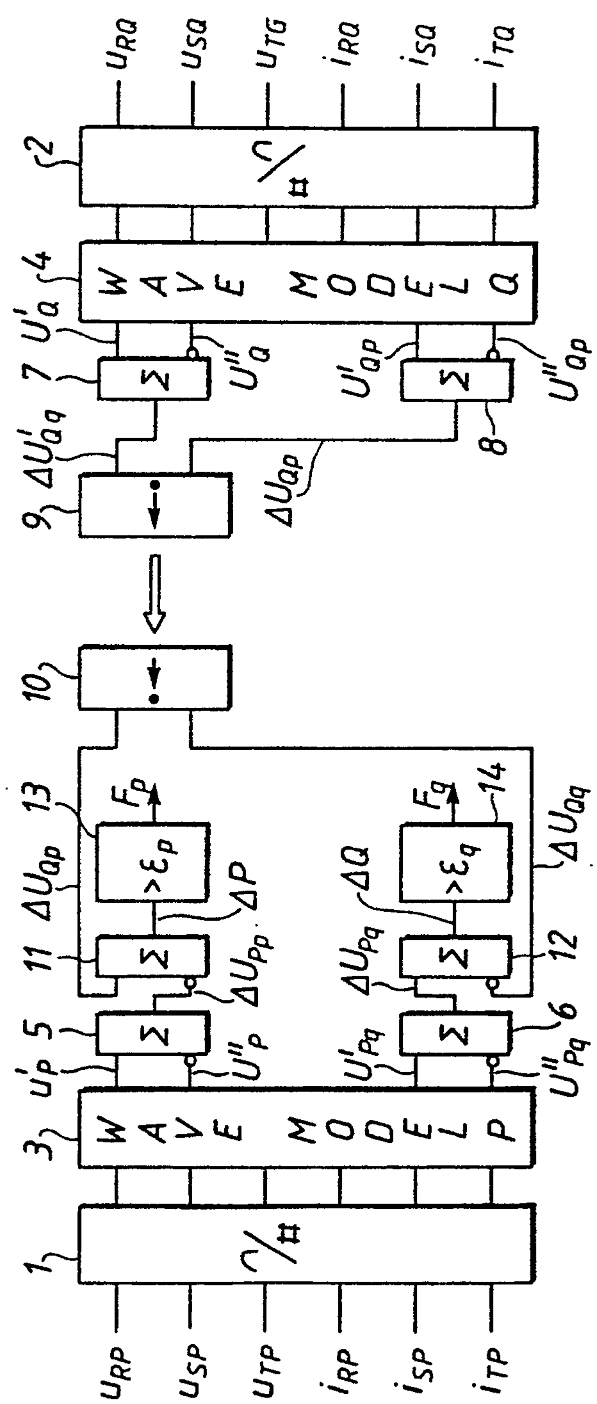
WAVE MODEL Q
WAVE MODEL P
Σ
$>\varepsilon_p$
$>\varepsilon_q$
$F_p$
$F_q$
$\Delta U_{Qp}$
$\Delta U_{Qq}$
$\Delta U'_{Qq}$
$\Delta U_{Pp}$
$\Delta U_{Pq}$
$\Delta P$
$\Delta Q$
$U'_P$
$U''_P$
$U'_{Pq}$
$U''_{Pq}$
$U'_Q$
$U''_Q$
$U'_{Qp}$
$U''_{Qp}$
$u_{RP}$
$u_{SP}$
$u_{TP}$
$i_{RP}$
$i_{SP}$
$i_{TP}$
$u_{RQ}$
$u_{SQ}$
$u_{TQ}$
$i_{RQ}$
$i_{SQ}$
$i_{TQ}$
1
2
3
4
5
6
7
8
9
10
11
12
13
14

FIG. 7